# EUROPEAN PATENT SPECIFICATION

(11) **EP 0 369 669 B1**
(45) Date of publication and mention of the grant of the patent: **15.06.1994**
(21) Application number: 89311557.6
(22) Date of filing: 08.11.1989
(51) Int. Cl.: G03F 1/00

(54) **Masking films**
Maskenfilm
Film formant masque

(30) Priority: 18.11.1988 GB 8827000
(43) Date of publication of application: 23.05.1990
(73) Proprietor: AUTOTYPE INTERNATIONAL LIMITED, Wantage Oxfordshire OX12 7BZ (GB)
(72) Inventor: Naisby, Andrew, Abingdon Oxfordshire OX14 3XR (GB); Sperry, John Arthur, Abingdon Oxfordshire OX14 2HJ (GB); Steel, John, Wantage Oxfordshire OX12 7JP (GB)
(74) Representative: Ackroyd, Robert

(56) References cited:
- EP-A- 0 188 292
- DE-A- 2 019 723
- FR-A- 2 206 866
- GB-A- 802 811
- US-A- 3 415 698

## Description

This invention relates to masking films, namely laminated sheet products of the kind comprising a stable transparent base film, which carries a coloured masking film or membrane in the form of a synthetic resin layer or coating. When the sheet product is to be used, the coloured membrane or film is cut through and can be peeled from the base film.

The resin layer or coating is dyed or pigmented, so that it has a high density to actinic light, but it is very desirable to maintain a good visual density. A layer of an adhesive sub-coat may be provided between the peelable masking membrane or film and the base film, in order to facilitate the removal of the cut mask. By cutting through the membrane and peeling parts of it away from the base, the product can be used as a photographic mask.

In colour printing, normally only four coloured inks are used. To reproduce coloured originals, the normal procedure is to produce from the original a set of four film negatives, either by camera techniques using carefully controlled colour filters or, more usually, by electronic scanning techniques. These negatives each represent one of the four colours, viz. cyan, magenta, yellow and black, which will ultimately be printed in register in order to produce the final colour print. It is very desirable to be able to "proof" the final print from this set of photographic negatives (or positives), without going to the expense of actually making plates and printing from them in four colours, and a considerable number of processes have been developed to achieve this objective. In many cases, a completely accurate colour rendition is not essential and, recently, several processes have been developed which exploit the use of standard photographic colour printing paper (photo-paper). This is exposed sequentially to the colour separation set, using carefully controlled and filtered lights. The end result is a "colour proof" which is not completely accurate with regard to the printing colours, but is a good approximation and is very adequate for most uses. It has the advantage of cheapness and speed, not least because standard colour paper processing is all that is required. For certain applications, it is desirable to use a masking film during the exposure sequence, for example when it is necessary to introduce blocks of text into the final colour proof. Owing to the panchromatic sensitivity of the photo-paper, standard masking films which are heavily dyed red, orange or yellow are not suitable. Neutral density (black) masking films are also not suitable: if pigmented to give a sufficient photographic density, the "see-through" properties are unacceptable, and vice versa.

This problem is exacerbated by the fact that, during each exposure, there is a small but finite amount of light which passes through the masking film. This may not be sufficient to fog the photo-paper being protected, but does have the effect of increasing the photosensitivity of the photo-paper, so that, during the multiple exposures necessary for producing the colour proof, the sensitivity of the photo-paper is increased to the point where fogging does take place.

Standard colour papers have a panchromatic sensitivity which is not even over the whole region of the spectrum. Because of the nature of dye sensitising agents currently used, the spectral sensitivity of such papers is at a minimum between 570 nm and 610 nm.

It is an object of the present invention to provide a masking film in which the absorption properties of the mask can be made closely to match the uneven spectral sensitivity of the photo-paper. With currently available photo-papers, this means that the mask should therefore have a low absorption of light in the 570 to 610 nm region of the spectrum and a high absorption of light outside that region. In other words, light in the aforesaid spectral range of 570 to 610 nm is permitted to pass through the mask, but light of other wavelengths is effectively blocked. Fortuitously, this 570 to 610 nm range corresponds with the maximum sensitivity of the human eye. The net result is that adequate "see-through" properties, together with very safe masking properties for multiple exposures, could thus be achieved. It has now been discovered that this desirable selective transparency of the masking film can be achieved by the selection and use of appropriate dyes.

The present invention provides a masking film for use with a photographic colour-printing medium in the preparation of colour proofs by sequential exposure of the medium to a colour separation set, the film comprising
a stable base film which is transparent to visible light and
a coloured masking layer in the form of a film or membrane which is carried by the film base and is peelable therefrom,
the coloured masking layer having a maximum transparency to visible light within the wavelength range from 570 nm to 610 nm, whilst being substantially opaque over the portions of the visible spectrum lying outside the said wavelength range.

Preferably, the light-absorption properties of the membrane are such that it has minimum transparency to light within the spectral range from 300 to 570 nm.

According to preferred embodiments of the invention, the masking layer has an optical density of 2 or greater over the spectral range from 300 to 570 nm and an optical density of less than 2 over the spectral range from 570 to 610 nm. The optical density is preferably substantially higher than 2 towards the 300 nm end of the 300 to 570 nm range.

The thickness of the membrane is preferably in the range from 5»m to 50»m.

An adhesive layer may be provided between the membrane and the base film.

The supporting base film is preferably selected from polyethyleneterephthalate, polybutyleneterephthalate, other polyester films, and polycarbonate. The masking membrane or film can be any of the dyed polymer mixtures disclosed for use as masking films. These include nitrocellulose heavily plasticised with phthalate esters, mixtures of PVC/VA with polyurethanes (EP-168924-A), nitrocellulose with nitrile rubber (EP-188292-A) and cellulose ester-PVC/VA -nitrile rubber (JP-87-17748 B). The membrane may be coated directly on to the base film or, optionally, a sub-coat may be applied between the base film and the dyed membrane. The purpose of this sub-coat is to improve or change the peel properties of the membrane. Typically, such a sub-coat consists of tackified natural rubber.

In order that the invention may be fully understood and appreciated, the following specific Examples are given, by way of illustration only.

### EXAMPLE 1

A panchromatic masking film was made from a base film in the form of a subbed polyester film, part (a), upon which was deposited, on the sub-coat side, a masking lacquer, formulated as described in part (b):

### (a) Sub Layer

An untreated graphic arts quality polyester film (e.g. Du Pont "Mylar® D") of 125»m (0.005in) thickness, was coated with an adhesive solution of the composition:

| Component | Quantity |
|---|---|
| *"Levapren® 452" | 10g |
| Toluene | 990g |
| | 1̅0̅0̅0̅g |
| The solution was applied to the polyester film by means of a 250»m (0.010in) wire wound bar (Meyer bar) and dried by warm air, to produce the desired subbed polyester base film. | |

| | |
|---|---|
| * "Levapren 452" is an ethylene-vinyl acetate copolymer of 45% vinyl acetate content manufactured by Bayer AG. | |

### (b) Masking Lacquer

The subbed polyester base film was overcoated on the sub layer with a coloured lacquer formulation by means of a 2-roll reverse coating technique and dried in a warm air oven. The composition of the lacquer was as follows:-

| Component | Quantity |
|---|---|
| Methyl Ethyl Ketone (Butanone) | 390g |
| *1 Dowanol® PM (Propylene Glycol Mono-Methyl-Ether) | 80g |
| *2 Cellulose Acetate Propionate (CAP) 482-0.5 | 85g |
| *2 Cellulose Acetate Propionate (CAP) 482-20 | 25g |
| *3 Permuthane® U4715 | 400g |
| *4 Degussa® OK412 | 3.9g |
| *5 Savinyl® Orange RLSE | 7.0g |
| *5 Savinyl® Blue GLS | 7.0g |
| *5 Savinyl® Yellow RLS | 0.40g |
| *6 Neozapon® Red 355 | 1.70g |
| | 1̅0̅0̅0̅.̅0̅0̅g |
| The coating was applied to gave an overall dry thickness of 30»m. | |

| | |
|---|---|
| *1 Dowanol PM is manufactured by Dow Chemicals | |
| *2 Cellulose acetate propionate is manufactured by Eastman Chemicals | |
| *3 Permuthane U4715 is a polyurethane solution of 30% n.v. in a solvent blend of 35% Toluene/35% Isopropyl alcohol and is manufactured by Stahl Chemicals, a subsidiary of I.C.I. Ltd. | |
| *4 Degussa OK412 is a silicaceous matting agent available from Degussa A.G. | |
| *5 Savinyl dyes are manufactured by Sandoz | |
| *6 Neozapon dyes are manufactured by B.A.S.F. | |

### Film Testing

The masking film so produced was a laminated sheet product having a brown-yellow appearance and showing good visual transparency.
Examination of the film on a Perkin-Elmer Lambda 7 spectrophotometer showed the film to have UV, blue and green densities in excess of 3.00 (the spectral region 350 to 550 nm) and a red density of average density of 3.0 (600 to 700 nm). Over the range of 550 to 600 nm a dip is recorded in spectral absorbance giving a D min at 580 nm of 2.1.

### Exposure Tests

To assess the film's performance as a panchromatic mask, exposure tests were conducted using Kodak Double Check colour paper and a Carlson Proofmaster exposure unit.
A sheet of mask along with a black card control was placed over a sheet of Double Check paper (in a lights-out darkroom) and given an exposure cycle to filtered red, green and blue light. Each exposure was of 200 units duration. The paper was then developed.
The developed paper was placed on a densitometer. The D min values of the paper masked both by card and film of this example were measured.
The process was repeated at 2x, 4x and 6x the initial exposure level. D min values were recorded as follows:-

| Number of Exposure Multiples | | | | | | | | | | | | |
|---|---|---|---|---|---|---|---|---|---|---|---|---|
| | 1x level | | | 2x level | | | 4x level | | | 6x level | | |
| | R | G | B | R | G | B | R | G | B | R | G | B |
| Control | 0.09 | 0.13 | 0.14 | 0.09 | 0.13 | 0.14 | 0.10 | 0.13 | 0.14 | 0.10 | 0.13 | 0.14 |
| Example 1 film | 0.09 | 0.13 | 0.14 | 0.09 | 0.13 | 0.14 | 0.10 | 0.13 | 0.14 | 0.10 | 0.13 | 0.14 |

As the results show, D min values remain unchanged. There was no fogging due to inadequacy of the mask.

### EXAMPLE 2

Polyester of 125»m (0.005in) thickness was subbed as in Example 1. The subbed layer was then overcoated with a masking lacquer of the following constitution to a thickness of 30»m

| Component | Quantity |
|---|---|
| CAP 482-0.5 | 106g |
| Permutane® U4715 | 333g |
| Degussa® OK412 | 4.6g |
| M.E.K. | 475g |
| * Stahl UP3771 Green | 60g |
| Savinyl® Yellow RLS | 19g |
| Neozapon® Red 355 | 2.4g |
| | 1̅0̅0̅0̅.̅0̅g |

| | |
|---|---|
| * Stahl UP3771 Green is a toluene-based dispersion of a phthalocyanine green pigment manufactured by Stahl Ltd. | |

### Testing

The film produced was of a deep green shade with good visual transparency. Examination of the spectrogram of this film showed densities in the 350 to 500 nm region to be in excess of 3.00.
Densities in the red spectral area (600 to 700 nm) were in excess of 4.00. The D min occurred in the 540 to 580 nm region and was measured at 2.1

### Exposure Tests

The tests outlined in Example 1 were repeated. Results were again as per control proving the formulation to have adequate shielding density for this process.

## Claims

1. A masking film for use with a photographic colour-printing medium in the preparation of colour proofs by sequential exposure of the medium to a colour separation set, the film comprising
a stable base film which is transparent to visible light and
a coloured masking layer in the form of a film or membrane which is carried by the film base and is peelable therefrom,
the coloured masking layer having a maximum transparency to visible light within the wavelength range from 570 nm to 610 nm, whilst being substantially opaque over the portions of the visible spectrum lying outside the said wavelength range.

2. A masking film according to claim 1, wherein the masking layer has an optical density of less than 2 over the wavelength range from 570 nm to 610 nm.

3. A masking film according to claim 2, wherein the masking layer has an optical density of 2 or greater over the wavelength range from 300 nm to 570 nm.

4. A masking film according to any preceding claim, wherein the optical density of the masking layer is substantially greater than 2 towards the 300 nm end of the wavelength range from 300 nm to 570 nm.

5. A masking film according to any preceding claim, wherein the film base is selected from polyethyleneterephthalate, polybutyleneterephthalate, other polyester films and polycarbonates and wherein the masking layer is selected from phthalate-ester-plasticised nitrocelluloses, polyvinylchloride/acetate mixtures with polyurethanes, nitrocellulose/nitrile rubber mixtures and cellulose ester/polyvinylchloride/acetate/nitrile rubber mixtures.

6. A masking film according to any preceding claim, wherein the masking layer is applied directly on to the base film.

7. A masking film according to any of claims 1 to 5, having an adhesive subbing layer between the base film and the masking layer.

## Patentansprüche

1. Maskenfilm zum Gebrauch bei einem fotografischen Farbdruckmedium bei der Herstellung von farbechten Abbildungen durch aufeinanderfolgende Belichtungen des Mediums mittels einer Farbtrennanordnung, wobei der Film
aus einem stabilen, für sichtbares Licht transparenten Basisfilm und
einer farbigen Maskenschicht in der Form eines Filmes oder einer Membran besteht, welche durch den Basisfilm getragen wird und von diesem abschälbar ist,
wobei die farbige Maskenschicht eine maximale Transparenz für sichtbares Licht innerhalb des Wellenlängenbereichs von 570 nm bis 610 nm aufweist, während sie in den Bereichen des sichtbaren Spektrums, die außerhalb dieses Wellenlängenbereichs liegen, im wesentlichen undurchsichtig ist.

2. Maskenfilm nach Anspruch 1, wobei die Maskenschicht über den Wellenlängenbereich von 570 nm bis 610 nm eine optische Dichte von weniger als 2 aufweist.

3. Maskenfilm nach Anspruch 2, wobei die Maskenschicht über den Wellenlängenbereich von 300 nm bis 570 nm eine optische Dichte von 2 oder mehr aufweist.

4. Maskenfilm nach einem der vorangegangenen Ansprüche, wobei die optische Dichte der Maskenschicht an dem 300 nm Ende des Wellenlängenbereichs von 300 nm bis 570 nm wesentlich größer als 2 ist.

5. Maskenfilm nach einem der vorangegangenen Ansprüche, wobei der Basisfilm aus Polyäthylenterephthalat, Polybutylenterephthalat, anderen Polyesterfilmen und Polycarbonaten ausgewählt ist und wobei die Maskenschicht aus mit Phthalatester plastifizierter Nitrozellulose, Polyvinylchlorid/Acetatmischungen mit Polyurethanen, Nitrozellulose/Nitrilkautschukmischungen und Mischungen aus Zelluloseester, Polyvinylchlorid, Acetat und Nitrilkautschuk besteht.

6. Maskenfilm nach einem der vorangegangenen Ansprüche, wobei die Maskenschicht unmittelbar auf den Basisfilm aufgebracht wird.

7. Maskenfilm nach einem der vorangegangenen Ansprüche 1 bis 5 mit einer Klebeunterschicht zwischen dem Basisfilm und dem Maskenfilm.

## Revendications

1. Film de masquage utilisable avec un support d'impression en couleur photographique dans la préparation d'épreuves en couleur par exposition séquentielle du support à un ensemble de séparation de couleur, le film comprenant :
un film de base stable qui est transparent à la lumière visible, et
une couche de masquage colorée sous la forme d'un film, ou d'une membrane, qui est porté par le film de base et peut être décollé de celui-ci,
la couche de masquage colorée ayant une transparence maximale à la lumière visible dans la plage de longueur d'onde de 570 nm à 610 nm, tout en étant sensiblement opaque dans les parties du spectre visible situées en dehors de ladite plage de longueur d'onde.

2. Film de masquage suivant la revendication 1, dans lequel la couche de masquage a une densité optique inférieure à 2 dans la plage de longueur d'onde comprise entre 570 nm et 610 nm.

3. Film de masquage suivant la revendication 2, dans lequel la couche de masquage a une densité optique de 2 ou plus dans la plage de longueur d'onde comprise entre 300 nm et 570 nm.

4. Film de masquage suivant une quelconque des revendications précédentes, dans lequel la densité optique de la couche de masquage est sensiblement supérieure à 2 vers l'extrémité du côté 300 nm de la plage de longueur d'onde allant de 300 nm à 570 nm.

5. Film de masquage suivant une quelconque des revendications précédentes, dans lequel le film de base est choisi parmi polyéthylène téréphtalate, polybutylène téréphtalate, autres films de polyester et polycarbonate, et dans lequel la couche de masquage est choisie parmi les nitrocelluloses plastifiées par phtalate ester, les mélanges de chlorure de polyvinyle/acétate avec des polyuréthanes, les mélanges de nitrocellulose/caoutchouc nitrile, et les mélanges de cellulose ester/chlorure de polyvinyle/acétate/caoutchouc nitrile.

6. Film de masquage suivant une quelconque des revendications précédentes, dans lequel la couche de masquage est appliquée directement sur le film de base.

7. Film de masquage suivant une quelconque des revendications 1 à 5, comportant une couche d'apprêt adhésive entre le film de base et la couche de masquage.
